# EUROPÄISCHE PATENTSCHRIFT

(11) **EP 1 012 973 B1**
(45) Veröffentlichungstag und Bekanntmachung des Hinweises auf die Patenterteilung: **16.01.2002**
(21) Anmeldenummer: 98949933.0
(22) Anmeldetag: 24.08.1998
(51) Int. Cl.: H03K 5/1252

(54) **DIGITALE SCHALTUNG MIT EINER FILTEREINHEIT ZUR UNTERDRÜCKUNG VON STÖRIMPULSEN**
DIGITAL CIRCUIT WITH FILTER UNIT FOR SUPPRESSING GLITCHES
CIRCUIT NUMERIQUE COMPORTANT UNE UNITE DE FILTRAGE POUR LA SUPPRESSION D'IMPULSIONS PARASITES

(30) Priorität: 08.09.1997 DE 19739245
(43) Veröffentlichungstag der Anmeldung: 28.06.2000
(73) Patentinhaber: Infineon Technologies AG, 81669 München (DE)
(72) Erfinder: LE, Thoai-Thai, D-81737 München (DE); BRASS, Eckhard, D-82008 Unterhaching (DE); BIEBL, Markus, D-86163 Augsburg (DE)
(74) Vertreter: Epping, Wilhelm, Dipl.-Ing.
(86) Internationale Anmeldenummer: DE9802476
(87) Internationale Veröffentlichungsnummer: WO9913573

(56) Entgegenhaltungen:
- EP-A- 0 009 549
- EP-A- 0 309 849
- US-A- 4 486 752
- US-A- 4 716 318

## Beschreibung

Die Erfindung betrifft eine digitale Schaltung mit einer Filtereinheit zur Unterdrückung von Störimpulsen.

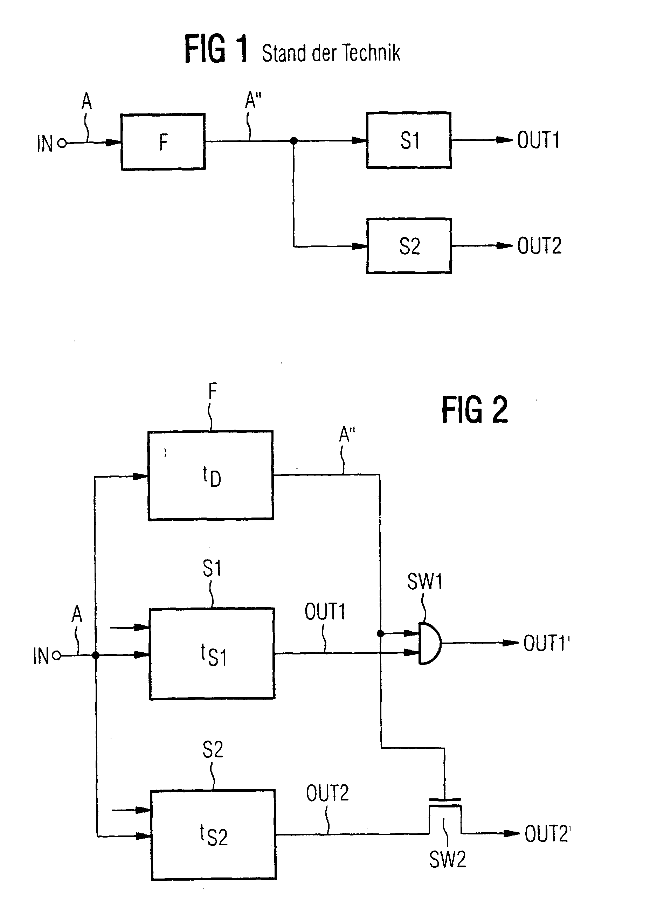

Figur 1 zeigt eine bekannte derartige Schaltung. Dargestellt sind logische Schaltungseinheiten S1, S2, denen über einen Eingang IN der digitalen Schaltung ein Eingangssignal A zugeführt werden soll. An Ausgängen OUT1, OUT2 der Schaltungseinheiten S1, S2 stellen sich dann entsprechende Ausgangssignale ein. Da das Eingangssignal A unter Umständen Störimpulse (Glitches) aufweisen kann, die sich nicht auf die Signale an den Ausgängen OUT1, OUT2 auswirken sollen, weist die Schaltung in Figur 1 einen Filter F auf, dem das mit Störimpulsen behaftete Eingangssignal A zugeführt wird und der daraus ein von Störimpulsen freies Signal A" erzeugt. Das gefilterte Signal A" wird dann den Schaltungseinheiten S1, S2 zugeführt.

Der beschriebene Stand der Technik hat den Nachteil, daß der Einsatz der Filtereinheit F, die eine Verzögerung des gefilterten Signals A' gegenüber dem Eingangssignal A bedingt, die gesamte Verzögerung bzw. Signallaufzeit zwischen dem Eingangssignal A und den Ausgangssignalen an den Ausgängen OUT1, OUT2 erhöht. Die Verzögerung zwischen dem Ausgang OUT1 und dem Eingang IN berechnet sich beispielsweise aus der Summe der Verzögerung durch die Filtereinheit F und der Verzögerung durch die erste Schaltungseinheit S1.

In der US 4,716,318 A ist ein Tiefpaßfilter für eine integrierte Schaltung beschrieben, der zwei im wesentlichen zueinander parallel angeordnete Teil-Tiefpaßfilter aufweist, von denen eines zum Filtern positiver Störimpulse und eines zum Filtern negativer Störimpulse vorgesehen ist und die ausgangsseitig über ein durch NOR-Gatter gebildetes Flip-Flop miteinander verknüpft sind.

Der Erfindung liegt die Aufgabe zugrunde, eine digitale Schaltung anzugeben, bei der Störimpulse eines Eingangssignals unterdrückt werden, ohne daß sich hierdurch die Signallaufzeiten zwischen dem Eingangssignal und einem Ausgangssignal der Schaltung wesentlich erhöhen.

Diese Aufgabe wird mit einer digitalen Schaltung gemäß Anspruch 1 gelöst. Weiterbildungen und Ausgestaltungen der Erfindung sind Gegenstand von abhängigen Ansprüchen.

Die erfindungsgemäße digitale Schaltung weist zwischen einem Signaleingang und wenigstens zwei Signalausgängen wenigstens zwei logische Schaltungseinheiten auf, deren Ausgänge über je ein Schaltelement mit einem der Signalausgänge der digitalen Schaltung verbunden sind. Dabei stellt sich am Ausgang der logischen Schaltungseinheiten in Abhängigkeit von Pegelwechseln eines Signals an ihrem Eingang ein Pegelwechsel eines Ausgangssignals ein. Weiterhin weist die digitale Schaltung eine Filtereinheit auf, deren Eingang ebenfalls mit dem Signaleingang verbunden ist und deren Ausgang mit einem Steuereingang der Schaltelemente verbunden ist, wobei die Filtereinheit Störimpulse auf einem an ihrem Eingang anliegenden digitalen Signal unterdrückt.

Bei der Erfindung wird ein gegebenenfalls mit Störimpulsen behaftetes Eingangssignal am Signaleingang ungefiltert den logischen Schaltungseinheiten, die zur Durchführung kombinatorischer Verknüpfungen (Schaltnetz) dienen, zugeführt, so daß ein Ausgangssignal am Ausgang der logischen Schaltungseinheiten durch die Störimpulse beeinflußt ist. Parallel zu den logischen Schaltungseinheiten wird das Eingangssignal jedoch auch der Filtereinheit zugeführt, die ein gefiltertes Signal erzeugt, das gegenüber dem Eingangssignal weniger oder im günstigsten Fall überhaupt keine Störimpulse aufweist. Das gefilterte Signal dient dann zur Steuerung der Schaltelemente, die günstigerweise ein logisches Gatter, z. B. ein UND- oder ODER-Gatter sind. Durch die Ansteuerung der Schaltelemente über das gefilterte Signal wird erreicht, daß diejenigen Teile des Ausgangssignals der logischen Schaltungseinheiten, die von den Störimpulsen des Eingangssignals beeinflußt sind, nicht an die Signalausgänge der digitalen Schaltung durchgeschaltet werden.

Die Erfindung hat den Vorteil, daß von Störimpulsen des Eingangssignals am Signaleingang freie Ausgangssignale an den Signalausgängen der digitalen Schaltung erzielt werden, ohne daß die Gesamtverzögerung zwischen diesen Signalen wesentlich länger ist, als die Signallaufzeit durch die logischen Schaltungseinheiten. Die erfindungsgemäße digitale Schaltung ist damit schneller, als die in Figur 1 dargestellte Schaltung.

Die Erfindung wird im folgenden anhand der Figuren, die Ausführungsbeispiele der Erfindung darstellen, näher erläutert.
- Figur 1: zeigt eine integrierte Schaltung nach dem in der Beschreibungseinleitung beschriebenen Stand der Technik;
- Figur 2: zeigt ein Ausführungsbeispiel der erfindungsgemäßen digitalen Schaltung;
- Figur 3 und Figur 4: zeigen Ausführungsbeispiele für die Filtereinheit aus Figur 2;
- Figur 5: zeigt einen Signalverlauf zu der Filtereinheit aus Figur 3;
- Figur 6: zeigt Signalverläufe zum in Figur 2 dargestellten Ausführungsbeispiel.

Figur 2 zeigt eine digitale Schaltung mit einem Signaleingang IN, einem ersten Signalausgang OUT1' und einem zweiten Signalausgang OUT2'. Den Signalausgängen OUT1', OUT2' ist jeweils ein Schaltelement SW1, SW2 vorgeschaltet. Das erste Schaltelement SW1 ist ein UND-Gatter und das zweite Schaltelement SW2 ist ein n-Kanal-Transistor. Eine erste logische Schaltungseinheit S1 ist eingangsseitig mit dem Signaleingang IN und ausgangsseitig mit einem Eingang des ersten Schaltelements SW1 verbunden. Eine zweite logische Schaltungseinheit S2 ist eingangsseitig ebenfalls mit dem Signaleingang IN und ausgangsseitig über das zweite Schaltelement SW2 mit dem zweiten Signalausgang OUT2' verbunden.

Bei den logischen Schaltungseinheiten S1, S2 handelt es sich bei diesem Ausführungsbeispiel um Schaltnetze zur Ausführung kombinatorischer Verknüpfungen. Die Erfindung ist auch auf andere Schaltungseinheiten anwendbar. Für alle Schaltungseinheiten S1, S2 muß aber gelten, daß sich an einem Ausgang OUT1, OUT2 nach einer gewissen Signallaufzeit ein Ausgangssignal einstellt, dessen Pegelwechsel abhängig von Pegelwechseln eines "high aktiven"-Eingangssignals A am Signaleingang IN ist. In Figur 2 ist auch angedeutet, daß die logischen Schaltungseinheiten S1, S2 weitere Eingänge aufweisen können, die nicht mit dem Signaleingang IN verbunden sind. Außerdem können die Schaltungseinheiten S1, S2 noch weitere Ausgänge aufweisen.

Figur 2 zeigt weiterhin eine Filtereinheit F, deren Eingang mit dem Signaleingang IN verbunden ist und deren Ausgang mit je einem Steuereingang der Schaltelemente SW1, SW2 verbunden ist. Beim Steuereingang des ersten Schaltelements SW1 handelt es sich um einen weiteren Eingang des UND-Gatters. Der Steuereingang des zweiten Schaltelements SW2 ist ein Gateanschluß des n-Kanal-Transistors. Es ist selbstverständlich, daß die Schaltelemente SW1, SW2 auch auf andere Weise realisiert sein können, insbesondere daß sie in beiden Fällen vom gleichen Typ sind, beispielsweise beides UND-Gatter. Die Filtereinheit F dient dazu, aus dem Eingangssignal A ein gefiltertes Signal A" zu erzeugen, bei dem Störimpulse, die das Eingangssignal A gegebenenfalls aufweist, unterdrückt sind. Mit diesem gefilterten Signal A" erfolgt die Ansteuerung der Schaltelemente SW1, SW2.

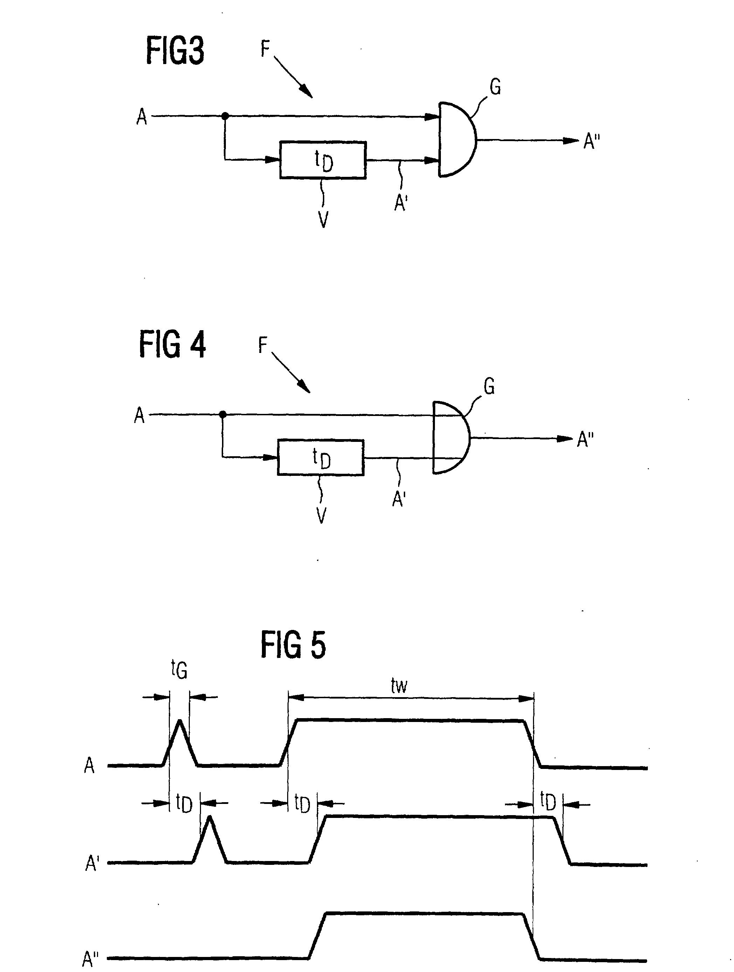

Figur 3 zeigt ein Ausführungsbeispiel der Filtereinheit F aus Figur 2. Sie dient zum Filtern positiver Störimpulse ("glitches") auf dem Eingangssignal A, dessen aktiver Pegel der hohe Pegel ist ("active high"). Die Filtereinheit F weist ein UND-Gatter G auf, an dessen Ausgang sich das gefilterte Signal A" einstellt. Einem ersten Eingang des UND-Gatters G wird das Eingangssignal A zugeführt. Einem zweiten Eingang des UND-Gatters G wird das Eingangssignal A über eine Verzögerungseinheit V mit einer zeitlichen Verzögerung t_{D} als verzögertes Eingangssignal A' zugeführt.

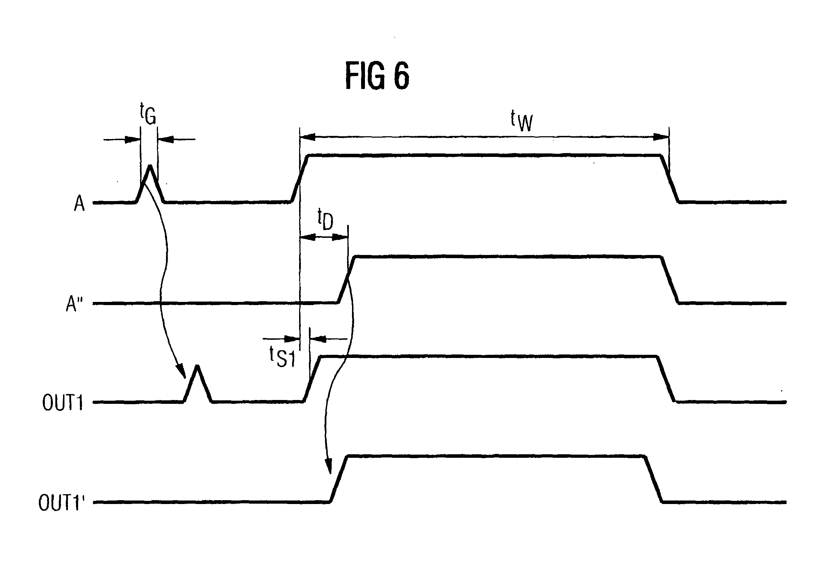

Figur 5 zeigt einen beispielhaften Signalverlauf für die in Figur 3 eingezeichneten Signale. Das Eingangssignal A weist zunächst einen positiven Störimpuls (Glitch) der Breite t_{G} auf, bevor das eigentliche Nutzsignal mit einer Breite t_{W} auftritt. Das verzögerte Signal A' am Ausgang der Verzögerungseinheit V ist gegenüber dem Eingangssignal A um die Verzögerungszeit t_{D} der Verzögerungseinheit V verschoben. Dementsprechend ergibt sich für das gefilterte Signal A" der gezeigte Verlauf, wobei das gefilterte Signal A" nur einen hohen Pegel aufweist, wenn sowohl das Eingangssignal A als auch das verzögerte Signal A' einen hohen Pegel aufweisen. Nur während des hohen Pegels des gefilterten Signals A" werden die Schaltelemente SW1, SW2 in Figur 2 durchgeschaltet, wie weiter unten anhand Figur 6 noch erläutert wird.

Um eine Unterdrückung von Störimpulsen auf dem Eingangssignal A durch die Filtereinheit F zu gewährleisten, muß die Verzögerung t_{D} der Verzögerungseinheit V in Figur 3 größer sein als die Breite t_{G} des Störimpulses. Störimpulse größerer Breite t_{G} werden durch die Filtereinheit nicht unterdrückt. Natürlich muß die Verzögerung t_{D} geringer sein als die Breite t_{W} des Nutzsignals.

Figur 4 zeigt ein weiteres Ausführungsbeispiel der Filtereinheit F zur Filterung von negativen Störimpulsen auf einem Eingangssignal, das "active low" ist. Der Unterschied zur Filtereinheit F gemäß Figur 3 besteht darin, daß anstelle eines UND-Gatters ein ODER-Gatter G verwendet wird. Bei Einsatz einer Filtereinheit F gemäß Figur 4 muß gegebenenfalls auch die Art der Schaltelemente SW1, SW2 in Figur 2 geändert werden. Ansonsten ist die Funktionsweise analog zu der, die im folgenden bezüglich der Filtereinheit F aus Figur 3 erläutert wird.

Figur 6 zeigt Signalverläufe einiger der in Figur 2 eingezeichneten Signale. Das Eingangssignal A und das gefilterte Signal A" wurden bereits anhand Figur 5 diskutiert. Weiterhin zeigt Figur 6 den Verlauf des Ausgangssignals OUT1 der ersten logischen Schaltungseinheit S1. Dieses weist Pegelwechsel auf, die abhängig von Pegelwechseln des Eingangssignals A sind. Gegenüber dem Eingangssignal A weist das Ausgangssignal OUT1 eine Signalverzögerung t_{S1} auf, die kürzer ist als die Verzögerung t_{D} durch die Filtereinheit F bzw. deren Verzögerungseinheit V. In Figur 6 ist ein Verlauf des Ausgangssignals OUT1 eingezeichnet. Das Ausgangssignal OUT1 weist Pegelwechsel auf, die durch den Störimpuls auf dem Eingangssignal A hervorgerufen sind. Ein solcher durch einen Störimpuls hervorgerufener Pegelwechsel soll aber nicht am Ausgang OUT1' der digitalen Schaltung erscheinen, da hierdurch die Funktion nachgeschalteter Schaltungseinheiten beeinträchtigt wird. Figur 6 ist zu entnehmen, daß das Signal am Ausgang OUT1 der ersten Schaltungseinheit S1 um deren Laufzeit t_{S1} verzögert ist.

In Figur 6 ist auch der Signalverlauf des Ausgangssignals OUT1' am Signalausgang der digitalen Schaltung eingezeichnet. Es ist ersichtlich, daß aufgrund der erfindungsgemäßen Ansteuerung des ersten Schaltelements SW1 durch das gefilterte Signal A" der durch den Störimpuls des Eingangssignals A ausgelöste Pegelwechsel des Ausgangssignals OUT1 am Ausgang der ersten logischen Schaltungseinheit S1 nicht an den Signalausgang OUT1' weitergegeben wird.

Anders als in Figur 2 dargestellt, kann die erfindungsgemäße digitale Schaltung auch lediglich eine der mit dem Signaleingang IN verbundenen logischen Schaltungseinheiten S1, S2 aufweisen oder auch mehr als zwei. Für eine fehlerfreie Funktion der Schaltung ist es in jedem Fall erforderlich, daß die Verzögerungszeit t_{D} der Filtereinheit F größer ist als die Verzögerungszeit t_{S1}, t_{S2} derjenigen logische Schaltungseinheit S1, S2, bei der dieser Wert am größten ist. Weiterhin ist es erforderlich, daß die in den Figuren 5 und 6 eingezeichnete Breite t_{W} des Nutzsignals des Eingangssignals A größer ist als die Signallaufzeit t_{S1}, t_{S2} der langsamsten logischen Schaltungseinheit S1, S2.

Figur 6 ist zu entnehmen, daß bei der Erfindung das Signal am Signalausgang OUT1' der digitalen Schaltung vorteilhafter Weise insgesamt nur um die Verzögerungszeit t_{D} der Filtereinheit F gegenüber dem Eingangssignal A verzögert ist (zuzüglich der Laufzeit des Schaltelements SW1). Damit ist die erfindungsgemäße digitale Schaltung schneller als die in Figur 1 gezeigte Schaltung, bei der das Ausgangssignal OUT1 gegenüber dem Eingangssignal A um die Summe aus der Verzögerungszeit der Filtereinheit F (die abhängig von der maximalen Breite t_{G} der zu unterdrückenden Störimpulse ist) und der Signallaufzeit der logischen Schaltungseinheit S1 verzögert ist. Bei der Erfindung ist die Gesamtverzögerung gleich der Verzögerung tD der Filtereinheit F. Diese muß, wie bereits erwähnt, nur geringfügig länger als die Laufzeit tS1 der Schaltungseinheit S1 sein.

Die Erfindung eignet sich zur Erhöhung der Störfestigkeit asynchroner digitaler Systeme, wie sie beispielsweise bei einigen Speichern, insbesondere DRAMS, vorliegen. Im Falle eines DRAMS eignet sich die Erfindung zum Beispiel zur Erzeugung interner Outputenable-, Writeenable-, CAS- (Column Adress Strobe) oder RAS- (Row Adress Strobe) Signale aus entsprechenden, gegebenenfalls mit Störimpulsen behafteten, externen Signalen.

Bei der Erfindung kann die Verzögerungszeit t_{D} der Filtereinheit F bei gleicher Gesamtverzögerung des Systems größer gewählt werden als beim anhand Figur 1 erläuterten Stand der Technik. Damit können bei der Erfindung, bei gleicher Gesamtverzögerung der Schaltung, Störimpulse größerer Breite t_{G} unterdrückt werden als es bisher der Fall war.

Die Erfindung weist noch einen weiteren Vorteil gegenüber der Schaltung aus Figur 1 auf: Die Zeitpunkte der Pegelwechsel der Ausgangssignale OUT1, OUT2 der Schaltung in Figur 1 sind jeweils ausschließlich abhängig von der Signallaufzeit durch die entsprechende logische Schaltungseinheit S1, S2. Bei der Erfindung dagegen sind die Zeitpunkte der Pegelwechsel der Signale an den Signalausgängen OUT1', OUT2' aufgrund der Ansteuerung der Schaltelemente SW1, SW2 über das gemeinsame gefilterte Signal A" aufeinander synchronisiert, so daß sich das Zeitverhalten des gesamten Systems wesentlich leichter vorherbestimmen läßt.

## Patentansprüche

1. Digitale Schaltung mit einem Signaleingang (IN) und wenigstens zwei Signalausgängen (OUT1', OUT2'),
- mit wenigstens zwei logischen Schaltungseinheiten (S1, S2) zur Ausführung logischer Operationen mit je einem Eingang, der mit dem Signaleingang (IN) verbunden ist und mit je einem Ausgang (OUT1, OUT2), der über je ein Schaltelement (SW1; SW2) mit einem der Signalausgänge (OUT1', OUT2') verbunden ist,
- bei der ein Pegelwechsel am Eingang der logischen Schaltungseinheiten (S1, S2) an deren Ausgängen (OUT1, OUT2) ebenfalls einen Pegelwechsel zur Folge hat,
- mit einer Filtereinheit (F) mit einem Eingang, der mit dem Signaleingang (IN) verbunden ist, die Störimpulse auf einem an ihrem Eingang anliegenden digitalen Signal (A) unterdrückt und dieses Signal ohne die Störimpulse an einem Ausgang ausgibt,
- bei der die Schaltelemente (SW1; SW2) jeweils einen Steuereingang aufweisen, der mit dem Ausgang der Filtereinheit (F) verbunden ist und über den sie in zwei Betriebszustände versetzbar sind,
- bei der im ersten Betriebszustand der Schaltelemente (SW1; SW2) das Signal am entsprechenden Signalausgang (OUT1', OUT2') mit demjenigen am Ausgang (OUT1, OUT2) der entsprechenden logischen Schaltungseinheit (S1, S2) übereinstimmt,
- bei der im zweiten Betriebszustand der Schaltelemente (SW1; SW2) das Signal am entsprechenden Signalausgang (OUT1', OUT2') unabhängig von demjenigen am Ausgang (OUT1, OUT2) der entsprechenden logischen Schaltungseinheit (S1, S2) ist,
- und bei der die Filtereinheit (F) die Schaltelemente (SW1; SW2) vor einem Pegelwechsel des digitalen Signals (A) am Signaleingang (IN) zunächst im zweiten Betriebszustand hält und sie bei Auftreten des Pegelwechsels nach einer zeitlichen Verzögerung (tD) in den ersten Betriebszustand versetzt, die größer als die Signallaufzeit (tS1) zwischen dem Eingang und dem Ausgang (OUT1, OUT2) derjenigen logischen Schaltungseinheit (S1, S2) ist, für die dieser Wert am größten ist.

2. Digitale Schaltung nach Anspruch 1,
bei der die Filtereinheit (F) ein logisches Gatter (G) enthält
- mit einem ersten Eingang, der mit dem Eingang der Filtereinheit (F) verbunden ist,
- mit einem zweiten Eingang, der über eine Verzögerungseinheit (V) mit dem Eingang der Filtereinheit (F) verbunden ist,
- und mit einem Ausgang, der mit dem Ausgang der Filtereinheit (F) verbunden ist.

3. Digitale Schaltung nach einem der vorhergehenden Ansprüche,
bei der eins der Schaltelemente (SW1) ein logisches Gatter oder ein Transistor ist.

## Claims

1. Digital circuit having a signal input (IN) and at least two signal outputs (OUT1', OUT2'),
- having at least two logic circuit units (S1, S2) for performing logic operations, each having an input connected to the signal input (IN), and each having an output (OUT1, OUT2) connected to one of the signal outputs (OUT1', OUT2') via a respective switching element (SW1; SW2),
- in which a level change at the input of the logic circuit units (S1, S2) likewise results in a level change at the outputs (OUT1, OUT2) of said units,
- having a filter unit (F) having an input connected to the signal input (IN), which filter unit suppresses glitches on a digital signal (A) present at its input and outputs this signal without the glitches at an output,
- in which the switching elements (SW1; SW2) each have a control input which is connected to the output of the filter unit (F) and via which they can be put into two operating states,
- in which, in the first operating state of the switching elements (SW1; SW2), the signal at the corresponding signal output (OUT1', OUT2') corresponds to that at the output (OUT1, OUT2) of the corresponding logic circuit unit (S1, S2),
- in which, in the second operating state of the switching elements (SW1; SW2), the signal at the corresponding signal output (OUT1', OUT2') is independent of that at the output (OUT1, OUT2) of the corresponding logic circuit unit (S1, S2),
- and in which the filter unit (F) initially holds the switching elements (SW1; SW2) in the second operating state prior to a level change of the digital signal (A) at the signal input (IN) and puts them into the first operating state in the event of the level change occurring after a time delay (tD) which is longer than the signal propagation delay (tS1) between the input and the output (OUT1, OUT2) of that logic circuit unit (S1, S2) for which this value is the greatest.

2. Digital circuit according to Claim 1,
in which the filter unit (F) contains a logic gate (G)
- having a first input connected to the input of the filter unit (F),
- having a second input connected to the input of the filter unit (F), via a delay unit (V),
- and having an output connected to the output of the filter unit (F).

3. Digital circuit according to one of the preceding claims,
in which one of the switching elements (SW1) is a logic gate or a transistor.

## Revendications

1. Circuit numérique ayant une entrée (IN) de signal et au moins deux sorties (OUT1', OUT2') de signal,
- comprenant au moins deux unités (S1, S2) de circuit logique pour effectuer des opérations logiques, ayant chacune une entrée qui est reliée à l'entrée (IN) de signal et ayant chacune une sortie (OUT1, OUT2) qui est reliée à l'une des sorties (OUT1', OUT2') de signal par respectivement un élément (SW1 ; SW2) de commutation,
- dans lequel un changement de niveau à l'entrée des unités (S1, S2) de circuit logique a également pour résultat un changement de niveau sur leur sortie (OUT1, OUT2),
- comprenant une unité (F) de filtrage ayant une entrée qui est reliée à une entrée (IN) de signal, l'unité (F) de filtrage supprimant les impulsions parasites sur un signal (A) numérique appliqué à son entrée et envoyant ce signal sans les impulsions parasites à une sortie,
- dans lequel les éléments (SW1 ; SW2) de commutation comportent respectivement une entrée de commande, qui est reliée à la sortie de l'unité (F) de filtrage et par laquelle ils peuvent être mis dans deux états de fonctionnement,
- dans lequel, lorsque les éléments (SW1 ; SW2) de commutation sont dans le premier état de fonctionnement, le signal à la sortie (OUT1', OUT2') de signal correspondant coïncide avec celui à la sortie (OUT1, OUT2) de l'unité (S1, S2) de circuit logique correspondant,
- dans lequel, lorsque les éléments (SW1 ; SW2) de commutation sont dans le deuxième état de fonctionnement, le signal à la sortie (OUT1', OUT2') de signal correspondant est indépendant de celui à la sortie (OUT1, OUT2) de l'unité (S1, S2) de circuit logique correspondant,
- et dans lequel l'unité (F) de filtrage maintient d'abord dans le deuxième état de fonctionnement les éléments (SW1, SW2) de commutation avant un changement de niveau du signal (A) numérique à l'entrée (IN) de signal et les met dans le premier état de fonctionnement après une temporisation (tD) qui est plus grande que la durée (tS1) de parcours du signal entre l'entrée et la sortie (OUT1, OUT2) de celle des unités (S1, S2) de circuit logique pour laquelle cette valeur est la plus grande.

2. Circuit numérique suivant la revendication 1,
dans lequel l'unité (F) de filtrage comporte un élément (G) logique
- ayant une première entrée qui est reliée à l'unité de (F) de filtrage,
- ayant une deuxième entrée qui est reliée à l'entrée de l'unité (F) de filtrage par l'intermédiaire d'une unité (V) de temporisation,
- et ayant une sortie qui est reliée à la sortie de l'unité (F) de filtrage.

3. Circuit numérique suivant l'une des revendications précédentes, dans lequel l'un des éléments (SW1) de commutation est un élément logique ou un transistor.
